(19) **Europäisches Patentamt**

**European Patent Office**

**Office européen des brevets**

(11) **EP 1 247 340 B1**

(12) **EUROPEAN PATENT SPECIFICATION**

(45) Date of publication and mention
of the grant of the patent:
**24.09.2003 Bulletin 2003/39**

(51) Int Cl.⁷: **H03K 19/00**, H03K 19/003,
H03K 17/16

(21) Application number: **00988798.5**

(22) Date of filing: **15.12.2000**

(86) International application number:
**PCT/EP00/12767**

(87) International publication number:
**WO 01/047119 (28.06.2001 Gazette 2001/26)**

(54) **LOW-POWER SIGNAL DRIVER WITH LOW HARMONIC CONTENT**

SIGNALTREIBER FÜR GERINGE LEISTUNGEN MIT NIEDRIGEM OBERWELLENGEHALT

CIRCUIT DE SORTIE DE SIGNAUX FAIBLE PUISSANCE, A FAIBLE DISTORSION HARMONIQUE

(84) Designated Contracting States:
**AT BE CH CY DE DK ES FI FR GB GR IE IT LI LU
MC NL PT SE TR**

(30) Priority: **22.12.1999 US 469682**

(43) Date of publication of application:
**09.10.2002 Bulletin 2002/41**

(73) Proprietor: **Telefonaktiebolaget L M Ericsson
(Publ)
126 25 Stockholm (SE)**

(72) Inventor: **SVENSSON, Lars
S-412 52 Göteborg (SE)**

(74) Representative: **Clarke, Alison Clare
Haseltine Lake,
Imperial House, 15-19 Kingsway
London WC2B 6UD (GB)**

(56) References cited:
**US-A- 5 559 447          US-A- 5 614 847
US-A- 5 724 297          US-A- 5 781 062
US-A- 5 933 384**

## Description

## BACKGROUND OF THE INVENTION

Technical Field of the Invention

The present invention relates generally to digital circuits and more particularly, but not by way of limitation, to low power signal drivers with low harmonic content.

Description of Related Art

From the early days of electronic components, size has been an important factor in component design. With the ever increasing integration of electronics into everyday life, component size has become a critical aspect of the design of electronic devices. Although the public is demanding more compact electronics, it is not willing to give up features that add size to those electronics. In fact, the demand for more compact electronic devices is only rivaled by the demand for more features in those devices. Electronic component designers are thus forced to miniaturize electronics while they integrate more features and more components into those electronics.

In no field is miniaturization and integration more important than in the field of circuit design. It is beneficial for a variety of reasons to be able to miniaturize circuits and to place more components in those circuits. Such miniaturization and integration results in, for example, a reduction in manufacturing costs, a reduction in overall device size, and the provision of more features in the same size device. For many electrical devices, especially cellular phones, it is equally beneficial to integrate digital and analog components. However, the integration of analog and digital components, when combined with ever increasing miniaturization, leads to electro-magnetic compatibility (EMC) problems. For example, in cellular phones, high-frequency analog signals are handled near digital circuitry and in particular, near digital switching circuitry such as that included in signal drivers. The digital circuitry can easily disrupt the high-frequency analog signals and create significant EMC problems.

Presently, EMC issues arising from the integration of digital and analog components are addressed by a multitude of methods--none of which are wholly satisfactory. Particularly unsatisfactory is the existing technology surrounding the EMC of semiconductor switches. Switching currents through switches, such as FETs, MOSs, etc., creates harmonics which can cause substantial electro-magnetic interference (EMI) in nearby analogy circuitry.

Existing techniques for dealing with EMI caused by switching currents center on reducing the level of the switching currents, i.e., by designing low-power circuits such as low-power signal drivers. For example, a reduction in the average switching current results in a corresponding decrease in the absolute level of the harmonic content of the switching current, and thus, a decrease in EMI. Further, by reducing switching currents and by designing low-power circuits, edge rates of the digital signals are reduced, thereby further reducing harmonic content.

In addition to addressing the EMC problem through the design of low-power circuits, electronics designers provide sensitive components with electro-magnetic shielding. Such shielding includes housings, screens or any other objects, usually conductive, that substantially reduce the effect of electro-magnetic fields originating on one side of the shielding upon devices on the other side of the shielding. Both low-power circuits and shielding, however, present significant drawbacks. First, neither method always suffices to prevent EMI. In other cases, the methods must be applied with such rigor that overall circuit design is compromised. The circuit may become too large, too slow and/or too expensive to manufacture. An alternative approach to low-EMI digital CMOS circuits involves higher power dissipation than the traditional styles. Circuit solutions are borrowed from bipolar-logic styles such as ECL, resulting in so-called current-mode logic. Such logic circuits carry significant current even when input signals are stable. Thus, in these systems, reducing EMI results in the highly undesirable effects associated with high power dissipation, e.g., battery drain, excessive heat generation, etc. In many technologies, such as cellular phone technology, this high power dissipation is as unacceptable as is EMI.

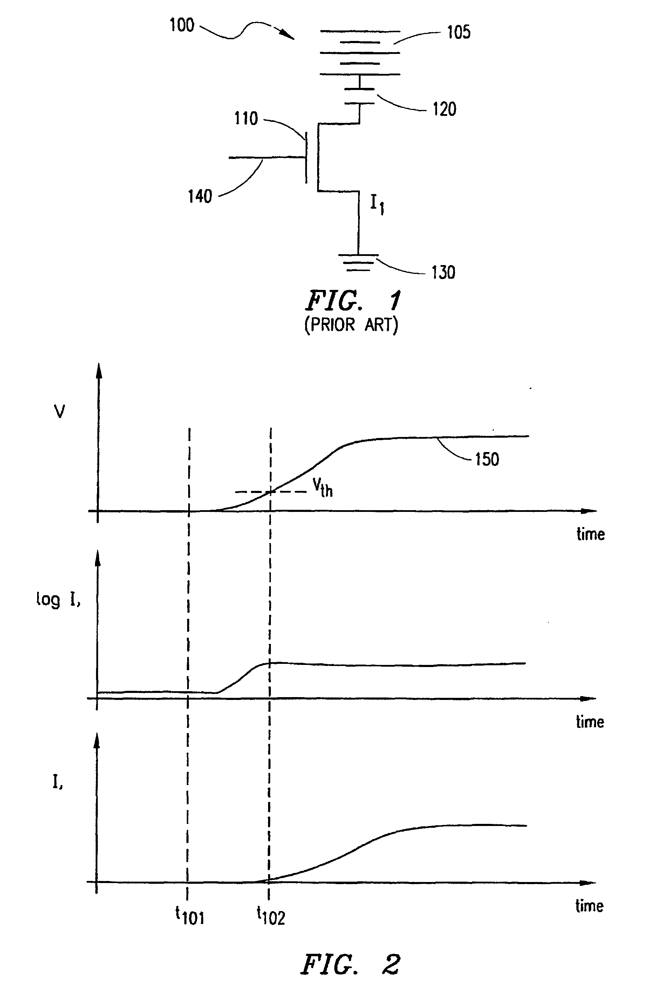

Because semiconductor switches are heavily used in modem circuitry (see, e.g., U.S. Patent No. 5,933,384), the properties of the switches, such as EMC and power dissipation, are important to circuit design. With regard to power dissipation, low-threshold, switches tend to leak more current when switched off than do high-threshold switches. Current leakage from the supply voltage through a nominally off switch to ground results in static power dissipation. It should be appreciated by those skilled in the art that although switch 110 (shown in FIGURE 1) is illustrated to include MOSFETs --MOSFETs are only one of many type of semiconductor switches (JFETs, MESFETs, etc...) that behave in the fashion illustrated in Figure 2.

Referring now to Figures 1 and 2, the switching circuit 100 includes a power supply 105, a field effect transistor 110 (FET) with a low-threshold voltage, a capacitance load 120 and ground 130. Also shown is an input 140. Input 140 serves to receive the input voltage which controls the FET 110, and thereby switch the FET 110 on. Thus, when the voltage at the input 140 equals or exceeds the threshold voltage, the FET 110 is switched on and current can flow from the power supply 105 to the ground 130. When the voltage at the input 140 is below the threshold voltage, the FET 110 is off. Ideally, when the FET 110 is off, no current would flow from the power supply 105 to the ground 130. However, the general relationship is that FETs with lower threshold voltages leak more current than FETs with higher threshold voltages when switched off. Figure 2 illustrates the current $I_1$ (bottom drawing) and the logarithm of the current $I_1$ (middle drawing), depending on the application of input voltage 150 (top drawing) applied to input 140. At time t101, the input voltage 150 is below the threshold level, e.g., 0 volts, and the FET 110 is off. At this point, the current $I_1$ is not zero, but rather somewhat higher than zero. The current is leaking through the FET 110. The amount of leakage depends on the particular parameters of the FET 110. The general relationship, again, is that FETs with lower threshold voltages leak more current than FETs with higher threshold voltages.

Still referring to Figure 2, at time t102, the input voltage 150 at input 140 equals the threshold voltage requirement of the FET 110. Thus, at time t102, the FET 110 is switched on. The current $I_1$, then rises to its designed output level. Although on the linear scale (bottom drawing) it appears that the current $I_1$ does not start to increase until the input voltage has reached the threshold voltage ($V_{th}$) at time t102, the current plot on the logarithmic scale (middle drawing) clearly shows that some current flows (leaks) with any level of voltage. The amount of current flow as related to the applied voltage is determined by the threshold voltage of FET 110. Importantly, the current $I_1$ is a monotonic function of the gate voltage: substantially exponential below the threshold and polynomial (with an exponent between 1 and 2) above it.

High-threshold FETs leak less current than do low-threshold FETs where the relationship between leakage current and threshold voltage can be represented as, to the first order:

$$I_{LEAK} \cong \exp(-(|V_T|/(n{*}V_{Th})))$$

where "$V_T$" is the threshold voltage, "$V_{th}$" is the thermal voltage (about 26mV at room temperature), and "n" typically takes a value between 1 and 2. Thus, the leakage current may increase by a factor of 10 for each 100 mV reduction in threshold voltage.

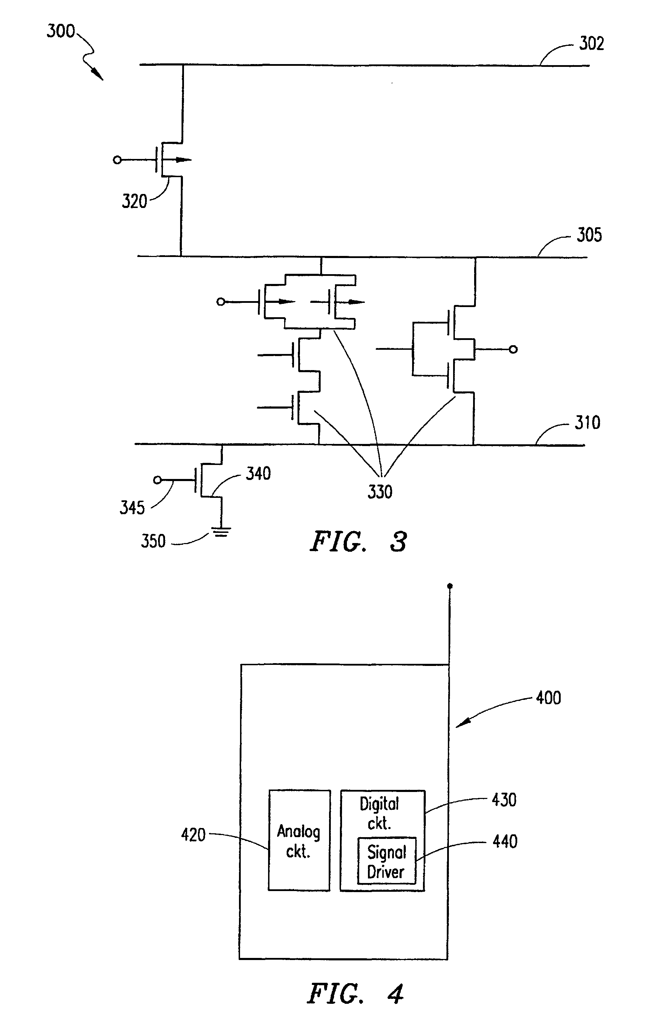

Although high-threshold FETs are advantageous in terms of preventing unnecessary power dissipation, they have drawbacks in other areas. For example, at the same gate-source voltage, high-threshold FETs provide lower drive capability than do low-threshold FETs. Further, high-threshold FETs have a slower switching speed than do the low-threshold FETs. Also, high-threshold FETs turn on less smoothly than do low-threshold FETs. Also, devices with a lower threshold voltage (with device widths adjusted for constant drive capability) will turn on more smoothly than higher-threshold devices. Because they turn on less smoothly, high-threshold FETs produce more troublesome harmonics and EMC problems than do the low-threshold FETs. In an attempt to capitalize on the beneficial properties of each type of switch, existing systems have employed circuits which use a combination of low and high-threshold circuitry. In these systems, low-threshold switches are used for the primary circuitry. This allows for fast response times generally associated with low-threshold switches. High-threshold switches are used to prevent the low-threshold switches, when not being used, from unnecessarily leaking. Figure 3 illustrates such a system used to limit power dissipation without regard to harmonic content as described by Shigematsu et al. in "*A 1-V High-Speed MTCMOS Circuit Scheme for Power-Down Application Circuits*" IEEE Journal of Solid-State Circuits, vol. 32, no. 6, pp. 861-869, June 1997. In Figure 3, there is shown a circuit 300 including a supply voltage line 302, a virtual supply line 305, a virtual ground line 310 and a ground line 350. One skilled in the art will readily appreciate that the circuit 300 is not a driver circuit, but rather, a logic-type circuit. Driver circuits are employed when the drive strength of a logic circuit is insufficient for the load. The switches in circuit 300 are not used in this fashion.

The circuit 300 includes high-threshold MOSs 320 and 340 having inputs 325 and 345, respectively. MOS 320 is connected between the voltage line 302 and the virtual voltage line 305. Similarly, MOS 340 is connected between the ground 350 and the virtual ground 310. When on, MOS 320 connects the virtual voltage line 305 with the voltage line 302, and MOS 340 connects the virtual ground 310 with the ground 350. The circuit 300 also includes a block of low-threshold MOSs 330 connected between the virtual voltage line 305 and the virtual ground line 310. The block of low-threshold MOSs 330 perform the logical function of the circuit 300.

The circuit 300 is used to obtain high switching speed though the use of the block of low-threshold MOSs 330 while leaking a minimal amount of current when the block of low-threshold MOSs 330 are in a standby state. The current drawn by circuit 300 consists of static (leakage) current and dynamic (switching) current. The switching current draw is caused by the circuit 300 doing actual work, whereas the leakage current is overhead. All else being equal, the static current grows when the threshold voltage of the devices in the low-threshold MOSs 330 is reduced.

A block of logic where the average static current is significant compared with the average dynamic current is a candidate for serial switches according to Shigematsu. Examples of such blocks are those which have many paths between the virtual supply lines 305 and 310, but where only a small number of these paths simultaneously carry switching current. A smaller block could also be a candidate, provided that the amount of switching current were reduced commensurably (such a block would be mostly idle). For a block to be a candidate, the overall design of the system must also guarantee that the block will be idle during certain periods, so that no malfunction will result when the supply voltages are disconnected by switches such as high-threshold MOSs 320 and 340.

Existing systems that combine high and low-threshold switches are limited to benefiting only logic circuits that contain significant blocks of low-threshold switches controlled by high-threshold switches to maximize power savings. Further, existing systems that combine high and low-threshold switches completely fail to address the issue of harmonics caused by switching currents. Finally, these existing systems fail to adequately address power dissipation and EMC in signal drivers for driving capacitance loads.

Accordingly, a device with general application is needed in which EMI is reduced without causing excessive power dissipation, increased manufacturing costs and/or decreased device performance.

## SUMMARY OF THE INVENTION

The present invention overcomes the above-identified problems as well as other shortcomings and deficiencies of existing technologies by providing, in one aspect of the present invention a signal driver comprising: a first high-threshold semiconductor switch; a first low-threshold semiconductor switch; a second low-threshold semiconductor switch; and a second high-threshold semiconductor switch; wherein a load is chargeable by sequentially switching on the first high-threshold semiconductor switch and the first low-threshold semiconductor switch connected to one another in series and further wherein the load is dischargeable by sequentially switching on the second high-threshold semiconductor switch and the second low-threshold semiconductor switch connected to one another in series.

The present invention can include analog circuitry located proximate the switches. This analog circuitry can include, but is not limited to, cellular telephone circuitry, telemetry circuitry and optical receiver circuitry.

In yet another aspect of the present invention, there is provided a method of driving a signal so as to reduce electromagnetic interference, the method comprising: switching on a first high-threshold switch; subsequently switching on a first low-threshold switch connected in series with the first high-threshold switch; discharging a load connected to the first low-threshold switch via a current flowing through the first low-threshold switch; switching on a second high-threshold switch connected in series with the first low-threshold switch; subsequently switching on a second low-threshold switch connected in series with the second high-threshold switch; and charging the load connected to the first low-threshold switch via a current flowing through the second low-threshold switch.

## BRIEF DESCRIPTION OF THE DRAWINGS

A more complete understanding of the present invention may be had by reference to the following Detailed Description and appended claims when taken in conjunction with the accompanying Drawings wherein:

Figure 1 (prior art) illustrates a low-threshold semiconductor switch;
Figure 2 (prior art) is a timing diagram showing the change in current output from the low-threshold semiconductor switch illustrated in Figure 1;
Figure 3 illustrates an existing logic circuit incorporating a combination of the low-threshold and high-threshold semiconductor switches illustrated in Figures 1 and 2;
Figure 4 illustrates a cellular telephone incorporating a signal driver of the present invention;
Figure 5 illustrates in greater detail a first embodiment of the signal driver illustrated in Figure 4;
Figure 5a is a timing diagram showing a current response to switching the semiconductor switches within the signal driver illustrated in Figure 5;
Figure 6 illustrates in greater detail a second embodiment of the signal driver illustrated in Figure 4;
Figure 6a is a timing diagram showing a current response to switching the semiconductor switches of the signal driver illustrated in Figure 6 such that a capacitance load is driven low; and
Figure 6b is a timing diagram showing a current response to switching the semiconductor switches of the signal driver illustrated in Figure 6 such that the capacitance load is driven high.

## DETAILED DESCRIPTION OF THE INVENTION

Referring now to the drawings wherein like numerals represent like parts throughout Figure 4-6a, there are disclosed two embodiments of an exemplary signal driver in accordance with the present invention.

Although the signal driver will be described in detail with reference to various digital circuit architectures, it will be readily understood by those skilled in the art that such signal drivers can be used in any circuitry including, for example, the mixed analog and digital circuitry often incorporated within cellular telephones.

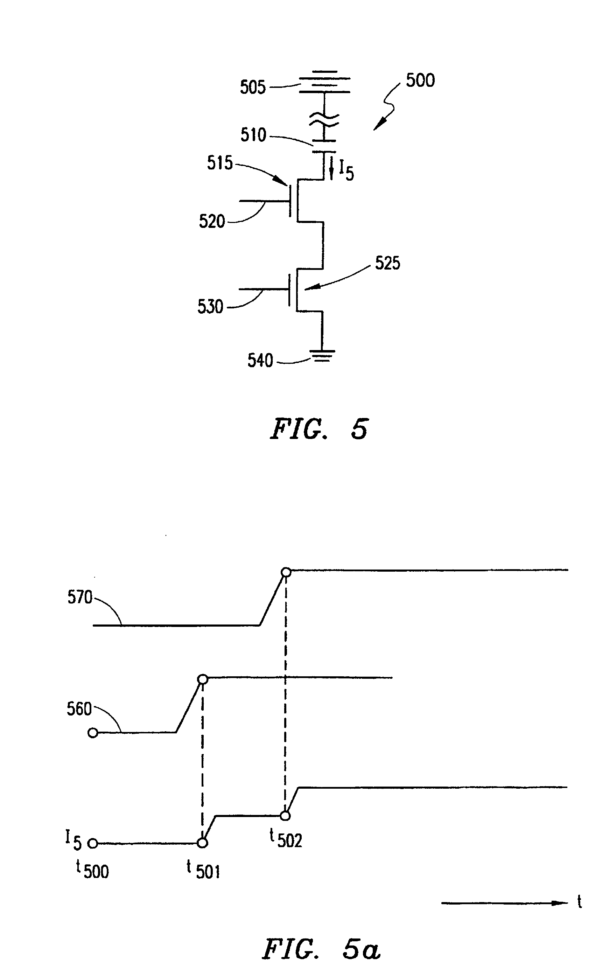

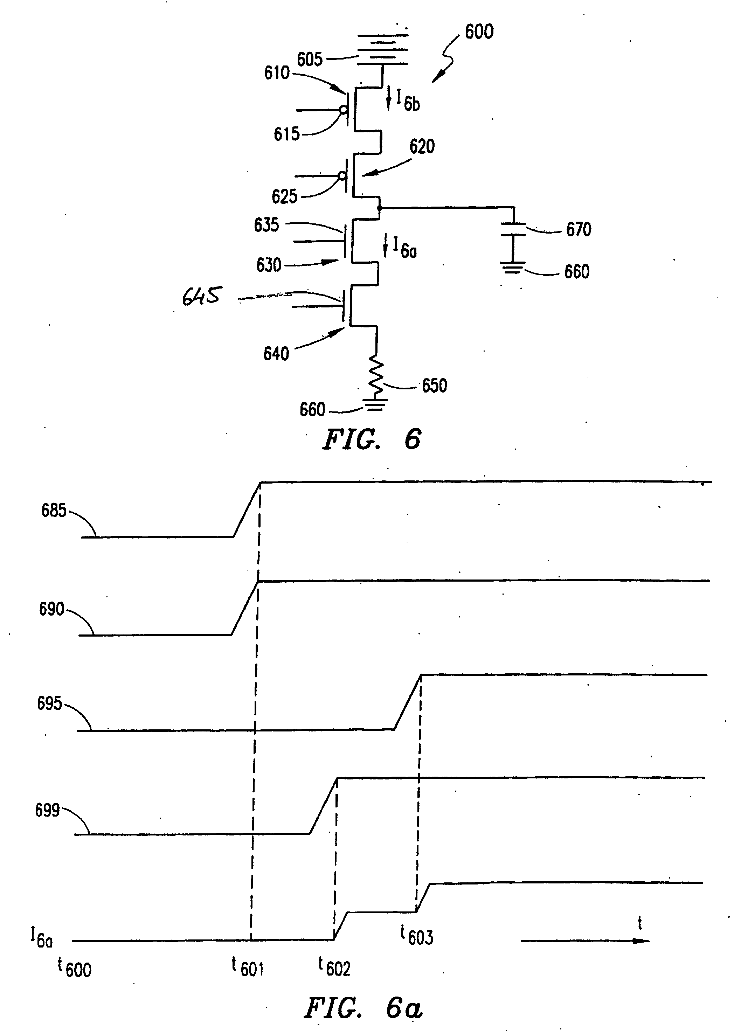

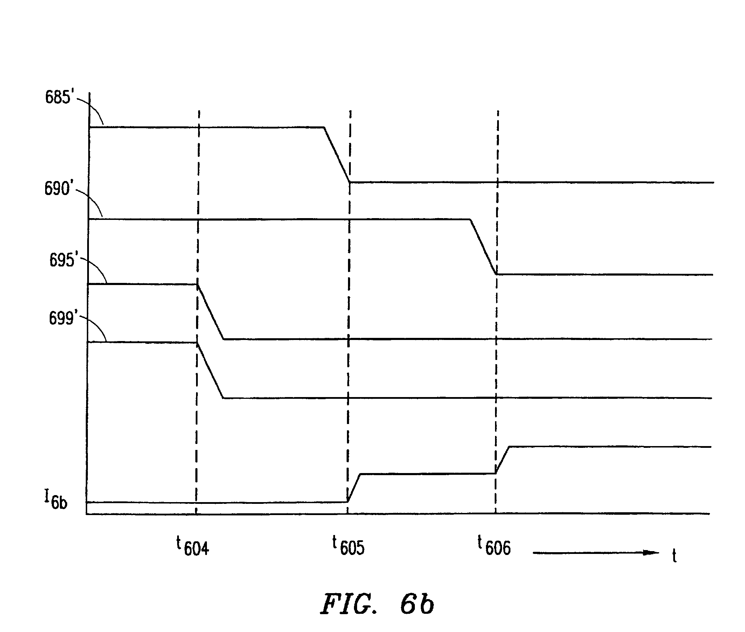

Referring now to Figure 4, there is illustrated a cellular telephone 400 with digital circuitry 430 and analog circuitry 420. The signal driver 440 (described below) is incorporated within the digital circuitry 430 to reduce the EMI on the nearby analog circuitry 420. The signal driver 440 has a particular architecture (see Figures 5 and 6) that reduces EMI by minimizing harmonic content in switching waveforms. Harmonic content of switching waveforms, and thus the EMI, is effected by predetermined threshold voltage levels of various semiconductor switches included in the signal driver 440.

As mentioned earlier, any driver using a single FET switch to connect the load with the supply line or the ground line presents a compromise between power and EMC requirements. A low-threshold FET, as shown in Figure 1, will produce less EMC problems than a higher-threshold equivalent, but it will also produce a level of power dissipation that may be unacceptable, especially in light of the increasing use and design demands for portable, battery-driven electronic devices. Less EMC and lower power dissipation levels can be achieved by using the signal driver 500 and 600 respectively illustrated in Figures 5 and 6.

Referring to Figure 5, there is illustrated the first embodiment of the signal driver 500 in accordance with the present invention. The signal driver 500 includes a power supply 505, a load 510, a low-threshold semiconductor switch 515 (FET 515), a high-threshold semiconductor 525 (FET 525), and ground 540, all of which are connected in series. FETs 515 and 525 are controlled by input lines 520 and 530, respectively. It should be understood that the semiconductor switches can be various types of semiconductor switches, including, for example, FETs, CMOSs, and MOSs.

The capacitance load 510 could be either an off-chip load or an on-chip load. For example, the capacitance load 510 can be a load presented by the package, by signal traces on a circuit board, by inputs of other chips such as memory chips, etc. Because the signal driver 500 is more complex than conventional drivers, it is contemplated that the best results will be obtained by using the signal driver 500 as a driver for large loads such as off-chip loads.

Referring now to Figure 5a, there is illustrated a timing diagram showing the response of current $I_5$ to switching at the signal driver 500. At time t500, the current $I_5$ will be zero or very near zero. At time t501, the input 530 is pulled high by voltage 560 and the high-threshold FET 525 is switched on. Corresponding to FET 525 being switched on, the current $I_5$ generally increases to the amount of current (e.g., subthreshold current) leaking through the low-threshold FET 515. The current $I_5$ can be provided by auxiliary pullup circuitry [not shown] or can be drawn from the capacitive load, which in that case would begin to slowly discharge.

Next at t502, input 520 is pulled high by voltage 570 and the low-threshold FET 515 is switched on. The current $I_5$ can then flow freely. As will be appreciated by one skilled in the art, the connection order of the low-threshold FET 515 and the high-threshold FET 525 can be altered without altering the operation of the circuit 500. For example, low-threshold FET 515 could be connected on the side of ground 540 and high-threshold FET 525 could be connected on the side of the capacitance load 510.

Although circuit 500, illustrated in Figure 5, is generally used to dissipate a capacitance load, similar circuitry can be used to charge the capacitance load. In fact, signal driver 600 illustrated in Figure 6 is designed to both charge and discharge the capacitance load in accordance with the principles of this invention.

Referring to Figure 6, there is illustrated the second embodiment of the signal driver 600 in accordance with the present invention. Signal driver 600 includes high-threshold FETs 610 and 640, low-threshold FETs 620 and 630, power 605, and ground 660, all of which are connected in series. As mentioned earlier, FETs 610, 620, 630 and 640 can be various types of semiconductor switches including, for example, FETs, CMOSs, MOSs, etc. The capacitance load 670 is connected between low-threshold FETs 620 and 630. Capacitance load 670 can either be charged or discharged with minimal harmonic content resulting in the switching current. The driven load is substantially capacitive but may include a resistive component 680.

Referring to Figure 6a, there is illustrated a timing diagram showing the response of current $I_{6a}$ when the capacitance load 670 is discharging. The input voltage at input 615 is illustrated by voltage 685, at input 625 by voltage 690, at input 635 by voltage 695, and at input 645 by voltage 699. At time t600, the voltage at inputs 615 and 625 is low. Because the input is inverted, the high-threshold FET 610 (pFET) and the low-threshold FET 620 (pFET) are correspondingly switched on. Also at time t600, voltages 695 and 699 are low. Thus, FETs 630 and 640 are switched off. At time t601, inputs 615 and 625 are pulled high by voltages 685 and 695, respectively. FET 610 and FET 620 are thus switched off. It should be understood that FET 610 and FET 620 can be switched off simultaneously or in some predetermined order.

At time t602, high-threshold FET 640 (nFET) is switched on by applying voltage 699, and current $I_{6a}$ begins to flow. The amount of the current is limited to the leakage of the low-threshold FET 630.

At time t603, the low-threshold FET 630 (nFET) is switched on by applying voltage 695, and the current $I_{6a}$ then fully flows. Although not shown, it will be appreciated by one skilled in the art that the current $I_{6a}$ will decay when the charge on the capacitive load decays. It will also be appreciated that the harmonic content attributable to discharging the capacitance load 670 will be less than using only the conventional high-threshold switch.

Referring to Figure 6b, there is illustrated a timing diagram showing the response of current $I_{6a}$ when charging the capacitance load 670. Input voltages 685', 690', 695' and 699' are applied to the input lines of FETs 610, 620, 630 and 640, respectively. It is assumed that FETs 630 and 640 have been on for a period of time and that the capacitance load 670 has been fully discharged.

At time t604, the FETs 630 and 640 are switched off by applying voltages 695' and 699' respectively. Although both FETs 630 and 640 are shown to switch off simultaneously, they can switch off at different times.

Next, at time t605, high-threshold FET 610 is switched on by applying voltage 685' and the current $I_{6b}$

rises to the leakage current of the low-threshold FET 620.

At time t606, the low-threshold FET 620 is switched on by pulling the input 625 low with voltage 695'. The current $I_{6b}$ then increases to its designed level and the capacitance load is rapidly charged. It can easily be appreciated that the harmonic content attributable to charging the capacitance load 670 using current $I_{6b}$ will be less than using only the conventional high-threshold switch.

It should be understood that there are many circuit solutions for generating waveforms for device gates not described above, and that one ordinarily skilled in the art could readily design such circuits in which topology is not critically important for the operation of the present invention.

It should also be understood that the connection order of the series devices (i.e., which device is to be connected to ground and which is to be connected to the load) are not essential to the invention. One characteristic is that for the output to transition, the high-threshold device is turned on first and the low-threshold device next. Extensions from simple inverter drivers to more complex combinational gates should be obvious to those skilled in the art. The most probable such extension is one where a more complex low-threshold gate is combined with single high-threshold cutoff device, although the dual situation applies when the driven signal is not often high. In cases of bursty switching activity, it may make sense to turn on all high-threshold devices and leave them on for the duration of the burst (there is a certain power dissipation cost for operating the cut-off devices).

From the foregoing, it can be readily appreciated by those skilled in the art that the above described invention provides a signal driver for reducing EMI while preserving power. The signal driver includes at least two series-connected semiconductor switches. One of the two switches having a low-threshold, and the other switch having a high-threshold. To discharge a capacitance load connected to one of the two switches, the high-threshold switch is switched on first. Next, the low-threshold switch is switched on. By turning on the two switches in this order, less harmonic content is introduced into the current flowing through the switches. Further, the two switches in series prevent unnecessary current leakage. In a generally similar fashion, the disclosed invention can be used to charge a capacitance load.

## Claims

1. A signal driver (600) comprising:

   a first high-threshold semiconductor switch (610);
   a first low-threshold semiconductor switch (620);
   a second low-threshold semiconductor switch (630); and
   a second high-threshold semiconductor switch (640);

   wherein a load (670) is chargeable by sequentially switching on the first high-threshold semiconductor switch (610) and the first low-threshold semiconductor switch (620) connected on one another in series and further wherein the load (670) is dischargeable by sequentially switching on the second high-threshold semiconductor switch (610) and the second low-threshold semiconductor switch (630) connected to one another in series.

2. The signal driver of claim 1, wherein the load (670) includes an off-chip capacitance load.

3. The signal driver of claim 2, wherein the load (670) includes an input load from a circuit.

4. The signal driver of claim 1, further comprising analog circuitry located proximate to digital circuitry, the digital circuitry including the first high-threshold switch and the first low-threshold switch.

5. The signal driver of claim 4, wherein the analog circuitry includes cellular phone analog circuitry.

6. A method of driving a signal so as to reduce electromagnetic interference, the method comprising:

   switching on a first high-threshold switch (610);
   subsequently switching on a first low-threshold switch (620) connected in series with the first high-threshold switch (610);
   discharging a load (670) connected to the first low-threshold switch (620) via a current flowing through the first low-threshold switch (620);
   switching on a second high-threshold switch (640) connected in series with the first low-threshold switch (620);
   subsequently switching on a second low-threshold switch (630) connected in series with the second high-threshold switch (620); and
   charging the load (670) connected to a first low-threshold switch (620) via a current flowing through the second low-threshold switch (630).

7. The method according to claim 6, wherein the load (670) includes an off-chip capacitance load.

8. The method according to claim 6, wherein the load (670) includes an input load from a circuit.

9. The method according to claim 6, further comprising discharging a load (670) connected to the first low-threshold switch (620) via a current flowing through the first low-threshold switch (610).

10. The method according to claim 6, further comprising charging a load (670) connected to the first low-threshold switch (620) via a current flowing through the second low-threshold switch (630).

## Patentansprüche

1. Signaltreiber (600), der folgendes aufweist:

   einen ersten Halbleiterschalter (610) hoher Ansprechschwelle;

   einen ersten Halbleiterschalter (620) niedriger Ansprechschwelle;

   einen zweiten Halbleiterschalter (630) niedriger Ansprechschwelle; und

   einen zweiten Halbleiterschalter (640) hoher Ansprechschwelle;

   wobei eine Last (670) durch sequentielles Schalten auf den ersten Halbleiterschalter (610) hoher Ansprechschwelle und den ersten Halbleiterschalter (620) niedriger Ansprechschwelle, die in Reihe miteinander verbunden sind, aufladbar ist, und wobei ferner die Last (670) durch sequentielles Schalten auf den zweiten Halbleiterschalter (640) hoher Ansprechschwelle und den zweiten Halbleiterschalter (630) niedriger Ansprechschwelle, die in Reihe miteinander verbunden sind, entladbar ist.

2. Signaltreiber gemäß Anspruch 1, wobei die Last (670) eine externe kapazitive Last aufweist.

3. Signaltreiber gemäß Anspruch 2, wobei die Last (670) eine Eingangslast von einer Schaltung aufweist.

4. Signaltreiber gemäß Anspruch 1, der ferner eine analoge Schaltungsanordnung aufweist, die in der Nähe einer digitalen Schaltungsanordnung angeordnet ist, wobei die digitale Schaltungsanordnung den ersten Schalter (610) hoher Ansprechschwelle und den ersten Schalter (620) niedriger Ansprechschwelle aufweist.

5. Signaltreiber gemäß Anspruch 4, wobei die analoge Schaltungsanordnung eine analoge Schaltungsanordnung eines Funktelefons aufweist.

6. Verfahren zum Treiben eines Signals derart, dass elektromagnetische Interferenzen herabgesetzt werden, wobei das Verfahren die folgenden Verfahrensschritte aufweist:

   Einschalten eines ersten Schalters (610) hoher Ansprechschwelle;

   Nachfolgendes Einschalten eines ersten Schalters (620) niedriger Ansprechschwelle, welcher in Reihe mit dem ersten Schalter (610) hoher Ansprechschwelle verbunden ist;

   Entladen einer mit dem ersten Schalter (620) niedriger Ansprechschwelle verbundenen Last (670) über einen Strom, der durch den ersten Schalter (620) niedriger Ansprechschwelle fließt;

   Einschalten eines zweiten Schalters (640) hoher Ansprechschwelle, welcher in Reihe mit dem ersten Schalter (620) niedriger Ansprechschwelle verbunden ist;

   Nachfolgendes Einschalten eines zweiten Schalters (630) niedriger Ansprechschwelle, welcher in Reihe mit dem zweiten Schalter (620) hoher Ansprechschwelle verbunden ist; und

   Laden der mit einem ersten Schalter (620) niedriger Ansprechschwelle verbundenen Last (670) über einen Strom, der durch den zweiten Schalter (630) niedriger Ansprechschwelle fließt.

7. Verfahren gemäß Anspruch 6, wobei die Last (670) eine externe kapazitive Last aufweist.

8. Verfahren gemäß Anspruch 6, wobei die Last (670) eine Eingangslast von einer Schaltung aufweist.

9. Verfahren gemäß Anspruch 6, welches ferner den Verfahrensschritt des Entladens einer mit dem ersten Schalter (620) niedriger Ansprechschwelle verbundenen Last (670) über einen Strom aufweist, der durch den ersten Schalter (620) niedriger Ansprechschwelle fließt.

10. Verfahren gemäß Anspruch 6, welches ferner den Verfahrensschritt des Ladens einer mit dem ersten Schalter (620) niedriger Ansprechschwelle verbundenen Last (670) über einen Strom aufweist, der durch den zweiten Schalter (630) niedriger Ansprechschwelle fließt.

## Revendications

1. Circuit d'attaque (600) de signaux comportant :

un premier commutateur (610) à semiconducteur à seuil haut ;
un premier commutateur (620) à semiconducteur à seuil bas ;
un second commutateur (630) à semiconducteurs à seuil bas ; et
un second commutateur (640) à semiconducteurs à seuil haut ;

dans lequel une charge (670) peut être chargée par une commutation séquentielle sur le premier commutateur (610) à semiconducteur à seuil haut et le premier commutateur (620) à semiconducteur à seuil bas connectés l'un à l'autre en série et dans lequel en outre la charge (670) peut être déchargée par une commutation séquentielle sur le second commutateur (610) à semiconducteur à seuil haut et le second commutateur (630) à semiconducteur à seuil bas connectés l'un à l'autre en série.

2. Circuit d'attaque de signaux selon la revendication 1, dans lequel la charge (670) comprend une charge capacitive extérieure à la puce.

3. Circuit d'attaque de signaux selon la revendication 2, dans lequel la charge (670) comprend une charge d'entrée provenant d'un circuit.

4. Circuit d'attaque de signaux selon la revendication 1, comportant en outre un circuit analogique placé à proximité d'un circuit numérique, le circuit numérique comprenant le premier commutateur à seuil haut et le premier commutateur à seuil bas.

5. Circuit d'attaque de signaux selon la revendication 4, dans lequel le circuit analogique comprend un circuit analogique de téléphone cellulaire.

6. Procédé d'attaque d'un signal pour réduire un brouillage électromagnétique, le procédé comprenant :

une commutation sur un premier commutateur (610) à seuil haut ;
une commutation, ensuite, sur un premier commutateur (620) à seuil bas connecté en série avec le premier commutateur (610) à seuil haut ;
la décharge d'une charge (670) connectée au premier commutateur (620) à seuil bas au moyen d'un courant circulant à travers le premier commutateur (620) à seuil bas ;
la commutation sur un second commutateur (640) à seuil haut connecté en série avec le premier commutateur (620) à seuil bas ;
la commutation, ensuite, sur un second commutateur (630) à seuil bas connecté en série avec le second commutateur (620) à seuil haut ; et
la charge de la charge (670) connectée à un premier commutateur (620) à seuil bas par l'intermédiaire d'un courant circulant à travers le second commutateur (630) à seuil bas.

7. Procédé selon la revendication 6, dans lequel la charge (670) comprend une charge capacitive à l'extérieur de la puce.

8. Procédé selon la revendication 6, dans lequel la charge (670) comprend une charge d'entrée provenant d'un circuit.

9. Procédé selon la revendication 6, comprenant en outre la décharge d'une charge (670) connectée au premier commutateur (620) à seuil bas au moyen d'un courant circulant à travers le premier commutateur (610) à seuil bas.

10. Procédé selon la revendication 6, comprenant en outre la charge d'une charge (670) connectée au premier commutateur (620) à seuil bas au moyen d'un courant circulant à travers le second commutateur (630) à seuil bas.

FIG. 1
(PRIOR ART)

FIG. 2

300

302

320

305

330

310

340

345

350

*FIG. 3*

400

Analog ckt.

Digital ckt.

Signal Driver

420

430

440

*FIG. 4*

FIG. 5

FIG. 5a

FIG. 6

FIG. 6a

FIG. 6b